# EUROPÄISCHE PATENTSCHRIFT

(11) **EP 2 202 761 B1**
(45) Veröffentlichungstag und Bekanntmachung des Hinweises auf die Patenterteilung: **13.04.2011**
(21) Anmeldenummer: 08291104.1
(22) Anmeldetag: 24.11.2008
(51) Int. Cl.: H01B 12/02

(54) **Anordnung mit einem supraleitfähigen Kabel**
Arrangement with a superconducting cable
Dispositif comprenant un câble supraconducteur

(43) Veröffentlichungstag der Anmeldung: 30.06.2010
(73) Patentinhaber: Nexans, 75008 Paris (FR)
(72) Erfinder: Soika, Rainer, Dr., 30559 Hannover (DE); Stemmle, Mark, Dipl.-Ing., 30161 Hannover (DE)
(74) Vertreter: Döring, Roger

(56) Entgegenhaltungen:
- WO-A-03/052775
- US-A1- 2006 211 579

## Beschreibung

Die Erfindung bezieht sich auf eine Anordnung mit einem supraleitfähigen Kabel, welches aus einem supraleitfähigen Leiter und einem denselben unter Zwischenschaltung eines Dielektrikums konzentrisch umgebenden supraleitfähigen Schirm besteht und welches unter Einschluß eines Freiraums zum Durchleiten eines Kühlmittels von einem Kryostat umgeben ist, der aus zwei konzentrisch zueinander angeordneten metallischen Rohren besteht, zwischen denen eine Vacuumisolierung angeordnet ist (WO 03/052775 A1).

Ein supraleitfähiges Kabel hat in heutiger Technik elektrische Leiter aus einem Verbundwerkstoff, welcher keramisches Material enthält, das bei ausreichend tiefen Temperaturen in den supraleitfähigen Zustand übergeht. Der elektrische Gleichstromwiderstand eines entsprechend aufgebauten Leiters ist bei ausreichender Kühlung Null, solange eine bestimmte Stromstärke nicht überschritten wird. Geeignete keramische Materialien sind beispielsweise YBCO (Yttrium-Barium-Kupfer-Oxid) oder BiSCCO (Wismut-Strontium-Kalzium-Kupfer-Oxid). Ausreichend niedrige Temperaturen, um ein derartiges Material in den supraleitfähigen Zustand zu bringen, liegen beispielsweise zwischen 67 K und 110 K. Geeignete Kühlmittel sind beispielsweise Stickstoff, Helium, Neon und Wasserstoff oder Gemische dieser Stoffe.

In der Anordnung nach der eingangs erwähnten WO 03/052775 A1 wird ein supraleitfähiges Kabel mit kaltem Dielektrikum eingesetzt. Es besteht aus einem auf einen rohrförmigen Träger aufgebrachten Innenleiter und einem konzentrisch dazu angeordneten Schirm, die durch das Dielektrikum (Isolierung) voneinander getrennt und auf Abstand gehalten sind. Der Leiter und der Schirm bestehen beispielsweise aus Bändern aus supraleitfähigem Material, wie YBCO oder BiSCCO, die dicht nebeneinander liegend mit langem Schlag um eine Unterlage herumgewickelt sind. Dieses bekannte supraleitfähige Kabel ist so aufgebaut, daß der supraleitfähige Schirm das Magnetfeld des supraleitfähigen Leiters im ungestörten Betrieb nach außen abschirmt. Im Falle eines Kurzschlusses ändert der Schirm seine Impedanz, so daß das Magnetfeld des Leiters nicht mehr vollständig abgeschirmt wird. Ein solcher Kurzschluß kann daher nicht nur zur Zerstörung des Kabels führen (burn-out), sondern es können außerhalb des Kryostats auch elektromagnetische Störungen auftreten.

Der Erfindung liegt die Aufgabe zugrunde, die eingangs geschilderte Anordnung so zu gestalten, daß die Auswirkungen eines Kurzschlusses wesentlich vermindert werden können, wobei gleichzeitig außerhalb des Kryostats nur sehr geringe elektromagnetische Störungen auftreten.

Diese Aufgabe wird gemäß der Erfindung dadurch gelöst, daß außerhalb des Schirms auf der ganzen Länge des Kabels eine rohrförmig geschlossene Schicht aus ferromagnetischem Material vorhanden ist.

Ferromagnetische Materialien im Sinne der Erfindung sind alle Materialien, die eine relative Permeabilität µᵣ größer 10 aufweisen. Im Falle eines Kurzschlusses verliert der Schirm des Kabels seine abschirmende Funktion weitestgehend. Die außerhalb desselben angeordnete Schicht aus ferromagnetischem Material gelangt dadurch in das vom Leiter des Kabels erzeugte Magnetfeld und bewirkt direkt eine wesentliche Erhöhung der Induktivität des Leiters, also eine Erhöhung seines elektrischen Widerstandes. Der über den Leiter fließende Kurzschlußstrom wird dadurch merklich und schnell begrenzt. Die bei bekannten Kabeln durch einen hohen Kurzschlußstrom auftretende Erwärmung ist dementsprechend vermindert. Der Effekt der Begrenzung des Kurzschlußstroms wird durch die in der Schicht aus ferromagnetischem Material entstehenden Ummagnetisierungsverluste weiter erhöht, wenn das supraleitfähige Kabel ein Wechselstromkabel ist. Das ferromagnetische Material schirmt außerdem das Magnetfeld des Leiters des Kabels nach außen ab. Elektromagnetische Störungen für außerhalb des Kryostats befindliche Aggregate können also kaum auftreten. Außerdem werden auf naheliegende andere Kabelphasen einwirkende Kräfte reduziert.

In bevorzugter Ausführungsform wird die Schicht aus ferromagnetischem Material am äußeren Umfang des Kryostats angeordnet. Dabei kann mit Vorteil das außen liegende Rohr des Kryostats selbst aus dem ferromagnetischen Material bestehen. Als ferromagnetisches Material wird vorzugsweise ein Material mit einer hohen relativen Permeabilität µᵣ verwendet. Es kann sowohl ein Material mit hohen Hytereseverlusten als auch ein Material mit geringen Hystereseverlusten zum Einsatz kommen, abhängig vom gewünschten Kabelverhalten im Kurzschlußstromfall. Die Schicht aus ferromagnetischem Material ist wie alle metallischen Materialien auch elektrisch leitfähig. Sie kann daher unter der Wirkung eines vom Leiter des Kabels gegebenenfalls ausgehenden magnetischen Wechselfeldes durch magnetische Hysterese und durch Wirbelströme erwärmt werden. Diese Erwärmung tritt aber bei der bevorzugten Ausführungsform der Anordnung außerhalb des Kryostats auf, so daß das Kabel selbst sowie das Kühlmedium hierdurch nicht erwärmt werden. Aufgrund der damit geringen Erwärmung sind die Rückkühlzeiten vermindert, so daß das Kabel schneller wieder einsatzfähig ist. Die geringere Erwärmung bedeutet auch geringere mechanische Beanspruchung der verschiedenen Komponenten der Anordnung. Schließlich bleibt auch das Kühlmittel von der Erwärmung der ferromagnetischen Schicht unberührt. Da außerdem wegen des reduzierten Kurzschlußstroms nur eine geringe Kühlleistung benötigt wird, kann bei dieser bevorzugten Ausführungsform der Anordnung auch die Auslegung der Kühlanlage vereinfacht werden.

Wenn für die Schicht aus ferromagnetischem Material ein Material mit sehr geringen Hystereseverlusten eingesetzt wird, dann wird die Schicht durch ein gegebenenfalls vom Leiter des Kabels erzeugtes Wechselfeld nur unwesentlich erwärmt. Ein solches Material hat mit Vorteil eine hohe relative Permeabilität µᵣ. Die Schicht aus ferromagnetischem Material kann insbesondere bei einem solchen Material auch innerhalb des Kryostats angeordnet werden. Sie kann dann beispielsweise den Schirm des Kabels direkt umgeben. Es könnte bei dieser Ausführungsform des Kabels auch das innere Rohr des Kryostats aus dem ferromagnetischen Material bestehen.

Ausführungsbeispiele des Erfindungsgegenstandes sind in den Zeichnungen dargestellt.

Es zeigen:

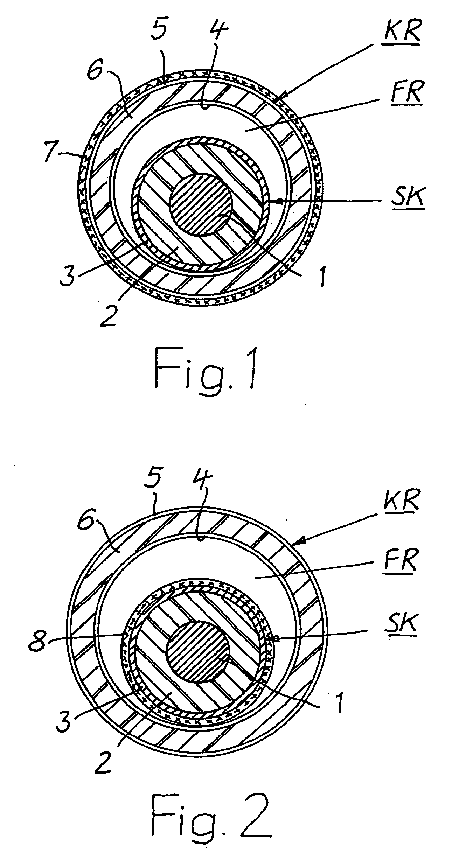

Fig. 1 und 2 Querschnitte durch zwei unterschiedlich aufgebaute Anordnungen nach der Erfindung in schematischer Darstellung.

Die Anordnung besteht gemäß den Fig. 1 und 2 aus einem supraleitfähigen Kabel SK und einem dasselbe umgebenden Kryostat KR. Der Kryostat KR schließt außerdem einen Freiraum FR ein, durch welchen beim Betrieb der Anordnung ein Kühlmittel geleitet wird, beispielsweise Stickstoff.

Das supraleitfähige Kabel SK besteht aus einem supraleitfähigen Leiter 1, einem denselben umgebenden, als Isolierung wirkenden Dielektrikum 2 und einem über dem Dielektrikum 2 angeordneten supraleitfähigen Schirm 3.

Der Kryostat KR ist aus zwei konzentrisch zueinander angeordneten, metallischen Rohren 4 und 5 aufgebaut, die vorzugsweise aus Stahl bestehen und zur Verbesserung der Biegbarkeit des Kryostats KR quer zu ihrer Längsrichtung gewellt sein können. Zwischen dem inneren Rohr 4 und dem äußeren Rohr 5 des Kryostats KR ist in bekannter Technik eine Vakuumisolierung 6 angebracht.

Gemäß Fig. 1 ist über dem äußeren Rohr 5 des Kryostats KR eine rohrförmig geschlossene Schicht 7 aus ferromagnetischem Material angebracht. Sie ist auf der ganzen Länge der Anordnung vorhanden und umgibt das Rohr 5 an seinem Umfang rundum. Die Schicht 7 ist also eine rohrförmig geschlossene Hülle. Sie hat in der Anordnung folgende Funktion:

Im Falle eines Kurzschlusses verliert der Schirm 3 des Kabels SK seine abschirmende Funktion weitestgehend. Die außerhalb desselben angeordnete ferromagnetische Schicht 7 gelangt dadurch in das vom Leiter 1 des Kabels SK erzeugte Magnetfeld und bewirkt direkt eine wesentliche Erhöhung der Induktivität des Leiters 1, also eine Erhöhung seiner elektrischen Impedanz. Der über den Leiter 1 fließende Kurzschlußstrom wird dadurch merklich und schnell begrenzt. Die durch den Kurzschlußstrom erzeugte Erwärmung des Kabels SK und seiner Umgebung wird also relativ niedrig gehalten, so daß der Energieaufwand für die Rückkühlung der Anordnung nach Behebung des Kurzschlusses relativ gering ist. Die ferromagnetische Schicht 7 schirmt außerdem das Magnetfeld des Leiters 1 nach außen ab. Elektromagnetische Störungen für außerhalb des Kryostats KR befindliche Aggregate können also nicht auftreten.

Wenn das supraleitfähige Kabel SK ein Wechselstromkabel ist, kann der den Kurzschlußstrom begrenzende Effekt durch in der ferromagnetischen Schicht gegebenenfalls entstehende Ummagnetisierungsverluste weiter erhöht werden.

Die Schicht 7 kann aus einem Band aus ferromagnetischem Material, wie beispielsweise Magneperm, aufgebaut sein, das mit überlappenden Kanten um das Rohr 5 herumgewickelt ist. Dieses Material hat eine relative Permeabilität von µᵣ = 450.000 bei 50 Hz. Die Schicht 7 könnte auch aus einem längseinlaufenden Band eines derartigen Materials hergestellt sein, welches das Rohr 5 mit einer in Längsrichtung verlaufenden Überlappungsstelle rundum umgibt.

Die Wandstärke der Schicht aus ferromagnetischem Material ist mit Vorteil größer als 0,1 mm. Die relative Permeabilität µᵣ des ferromagnetischen Materials ist größer als 10.

Ferromagnetische Materialien zeichnen sich allgemein durch eine hohe relative Permeabilität µᵣ aus. Unabhängig davon haben ferromagnetische Materialien Hystereseverluste, die durch die umschlossene Fläche im B-H-Diagramm gegeben sind. Beide Größen sind vom verwendeten Material abhängig. Es besteht keine Korrelation zwischen µᵣ und den Hystereseverlusten.

Statt einer gesonderten bzw. zusätzlichen Schicht 7 kann in einer abgewandelten Ausführungsform der Anordnung nach Fig. 1 auch das äußere Rohr 5 des Kryostats KR selbst aus ferromagnetischem Material bestehen, beispielsweise aus einem Stahl mit einer relativen Permeabilität von µᵣ= 1.000 bei 50 Hz. Geeignet sind auch Legierungen aus Nickel und Eisen mit weiteren Beimischungen in geringen Mengen.

Wichtig ist, daß die Schicht aus ferromagnetischem Material in allen Ausführungsformen als rundum geschlossene Schicht außerhalb des supraleitfähigen Schirms 3 angeordnet ist, damit sie im Kurzschlußfall im Magnetfeld des Leiters 1 liegt. Sie kann dementsprechend gemäß Fig. 2 auch innerhalb des Kryostats KR angeordnet sein und als Schicht 8 beispielsweise außen am Schirm 3 anliegen. Für die Schicht 8 wird - wie bereits erwähnt - mit Vorteil ein Material mit sehr geringen Hystereseverlusten eingesetzt, so daß dieselbe im Kurzschlußfall nur unwesentlich erwärmt wird. Die Schicht 8 kann dann an das gleiche Potential wie der Schirm 3 angeschlossen sein. Statt der gesonderten Schicht 8 kann - analog zu Fig. 1 - auch das innere Rohr 4 des Kryostats KR aus ferromagnetischem Material hergestellt sein. Auch bei dieser Ausführungsform der Anordnung mit innerhalb des Kryostats KR liegendem ferromagnetischem Material ergibt sich die Begrenzung des im Leiter 1 fließenden Kurzschlußstroms, so wie es für die Anordnung nach Fig. 1 beschrieben ist.

## Patentansprüche

1. Anordnung mit einem supraleitfähigen Kabel, welches aus einem supraleitfähigen Leiter und einem denselben unter Zwischenschaltung eines Dielektrikums konzentrisch umgebenden supraleitfähigen Schirm besteht und welches unter Einschluß eines Freiraums zum Durchleiten eines Kühlmittels von einem Kryostat umgeben ist, der aus zwei konzentrisch zueinander angeordneten metallischen Rohren besteht, zwischen denen eine Vacuumisolierung angeordnet ist, **dadurch gekennzeichnet, daß** außerhalb des Schirms (3) auf der ganzen Länge des Kabels (SK) eine rohrförmig geschlossene Schicht (7,8) aus ferromagnetischem Material vorhanden ist.

2. Anordnung nach Anspruch 1, **dadurch gekennzeichnet, daß** die relative Permeabilität des ferromagnetischen Materials größer 10 ist.

3. Anordnung nach Anspruch 1 oder 2, **dadurch gekennzeichnet, daß** die Schicht (7) aus ferromagnetischem Material außen auf das äußere Rohr (5) des Kryostats (KR) aufgetragen ist.

4. Anordnung nach Anspruch 1 oder 2, **dadurch gekennzeichnet, daß** das äußere Rohr (5) des Kryostats (KR) aus ferromagnetischem Material besteht.

5. Anordnung nach Anspruch 1 oder 2, **dadurch gekennzeichnet, daß** das ferromagnetische Material innerhalb des Kryostats (KR) angeordnet ist.

6. Anordnung noch Anspruch 5, **dadurch gekennzeichnet, daß** eine Schicht (8) aus ferromagnetischem Material außen auf den Schirm (3) aufgetragen ist.

7. Anordnung noch Anspruch 5, **dadurch gekennzeichnet, daß** das innere Rohr (4) des Kryostats (KR) aus ferromagnetischem Material besteht.

## Claims

1. Arrangement having a superconductive cable which consists of a superconductive conductor and a superconductive screen which surrounds the latter with the interposition of a dielectric and which is surrounded, with the inclusion of a free space for the insertion of a cooling medium, by a cryostat which consists of two metal tubes arranged concentrically to each other, between which vacuum insulation is positioned, **characterized in that** a tubularly closed layer (7,8) of a ferromagnetic material is provided outside the screen (3) over the entire length of the cable (SK).

2. Arrangement according to claim 1, **characterized in that** the relative permeability of the ferromagnetic material is more than 10.

3. Arrangement according to claim 1 or 2, **characterized in that** the layer(7) of ferromagnetic material is applied externally onto the outer tube (5) of the cryostat (KR).

4. Arrangement according to claim 1 or 2, **characterized in that** the outer tube (5) of the cryostat (KR) consists of ferromagnetic material.

5. Arrangement according to claim 1 or 2, **characterized in that** the ferromagnetic material is arranged inside the cryostat (KR).

6. Arrangement according to claim 5, **characterized in that** a layer (8) of ferromagnetic material is applied externally onto the screen (3).

7. Arrangement according to claim 5, **characterized in that** the inner tube (4) of the cryostat (KR) consists of ferromagnetic material.

## Revendications

1. Agencement comprenant un câble supraconducteur, qui se compose d'un conducteur supraconducteur et d'un blindage supraconducteur entourant concentriquement ce dernier en interposant un diélectrique, et qui est entouré par un cryostat tout en incluant un espace libre pour le passage d'un fluide réfrigérant, le cryostat se composant de deux tubes métalliques disposés concentriquement l'un par rapport à l'autre, entre lesquels est disposée une isolation sous vide, **caractérisé en ce qu'**à l'extérieur du blindage (3) sur toute la longueur du câble (SK) est prévue une couche fermée tubulaire (7, 8) en matériau ferromagnétique.

2. Agencement selon la revendication 1, **caractérisé en ce que** la perméabilité relative du matériau ferromagnétique est supérieure à 10.

3. Agencement selon la revendication 1 ou 2, **caractérisé en ce que** la couche (7) en matériau ferromagnétique est appliquée à l'extérieur sur le tube extérieur (5) du cryostat (KR).

4. Agencement selon la revendication 1 ou 2, **caractérisé en ce que** le tube extérieur (5) du cryostat (KR) se compose de matériau ferromagnétique.

5. Agencement selon la revendication 1 ou 2, **caractérisé en ce que** le matériau ferromagnétique est disposé à l'intérieur du cryostat (KR).

6. Agencement selon la revendication 5, **caractérisé en ce qu'**une couche (8) en matériau ferromagnétique est appliquée à l'extérieur sur le blindage (3).

7. Agencement selon la revendication 5, **caractérisé en ce que** le tube intérieur (4) du cryostat (KR) se compose de matériau ferromagnétique.
